# EUROPEAN PATENT APPLICATION

(11) **EP 0 680 089 A1**
(43) Date of publication of application: **02.11.1995**
(21) Application number: 94830201.3
(22) Date of filing: 28.04.1994
(51) Int. Cl.: H01L 27/02

(54) **Power semiconductor device with overvoltage protection circuit integrated structure, and related manufacturing process**

(71) Applicant: CONSORZIO PER LA RICERCA SULLA MICROELETTRONICA NEL MEZZOGIORNO, I-95121 Catania (IT)
(72) Inventor: Frisina, Ferruccio, I-95030 Sant'Agata li Battiati (Catania) (IT); Fallica, Piergiorgio, I-95129 Catania (IT)
(74) Representative: Mittler, Enrico

(57) **Abstract**

An integrated structure power device with overvoltage protection comprises at least a first plurality of serially-connected diodes (D1-D6) connected between a driving electrode (G) and a first power electrode (C) of the power device (T); the diodes (D1-D6) are polysilicon diodes, and each diode (D1-D6) comprises a first electrode, constituted by a respective first, heavily doped region (17) of a first conductivity type of a polysilicon layer (8''), and a second electrode, constituted by a respective second, doped region (18,12) of a second conductivity type of the polysilicon layer (8''); the polysilicon layer (8'') is isolated from an underlying silicon layer (3), wherein the power device (T) is integrated, by an insulating layer (4).

## Description

The present invention relates to a power semiconductor device with overvoltage protection circuit integrated structure, and to a related manufacturing process.

Power semiconductor devices must be protected against overvoltages which are generated during switching transients.

A known protection circuit for power bipolar junction transistors comprises a diode connected across the collector-base junction and having a breakdown voltage lower than the open-base collector-emitter breakdown voltage BV_{CEO} of the bipolar junction transistor. Such protection circuit assures the protection against overvoltages produced at the output (i.e. at the collector terminal) of the power device when, for example, it drives an inductive load.

MOS power devices, wherein the control (gate) electrode is isolated from a semiconductor substrate by a thin oxide layer (gate oxide), must be protected against overvoltages occurring not only at their output (i.e. at the drain terminal), but also at their input. The maximum driving voltage that the control electrode can sustain depends in fact on the thickness of the gate oxide layer: since such thickness is generally of few hundred of Angstroms, the maximum driving voltage is in the range of some tens of Volts. For higher driving voltages, electric discharges take place through the thin oxide layer, causing the device destruction. Output protection circuits are also necessary since during switching transients, exspecially when the power device is turned off, the power device is simultaneously submitted to high voltages and high currents, which cause reverse second breakdown and/or harmful voltage transients.

An example of power device with overvoltage protection circuit integrated structure is represented by a vertical darlington bipolar device obtained by diffusion of two N+ emitter regions into two respective P-type base regions, which are in turn diffused into a lightly doped N-type semiconductor layer superimposed over a more heavily doped N-type epitaxial layer; the two N-type layers form a common collector region for the two bipolar junction transistors of the darlington pair. The protection circuit is represented by a floating-base vertical bipolar transistor with emitter connected to the base of the output transistor of the darlington pair; under the P-type floating-base region, at the interface between the lightly doped N-type layer and the N-type epitaxial layer, an N+ region is provided (by ion implantation prior to the lightly doped N-type layer epitaxial growth). The floating-base vertical transistor has a BV_{CEO} lower than those of the transistors of the darlington pair, due to the reach-through between the collector-base and emmitter-base depletion regions.

Another example of power device with overvoltage protection circuit integrated structure is represented by a vertical darlington bipolar device similar to the previous one, obtained by diffusion of two P-type base regions into a lightly-doped N-type semiconductor layer superimposed over a heavily doped N-type substrate; the protection circuit is represented by a junction diode having an N-type cathode region extending between the two P-type base regions of the darlington-connected transistors, obtained by diffusion into the lightly doped N-type layer, and a P+ type anode region obtained by diffusion into the N-type cathode region. The N-type cathode region, being more heavily doped than the lightly doped N-type layer, lowers the electric field to a value of few Volts/micron before reaching the lightly doped N-type layer.

A third example of power device with overvoltage protection circuit integrated structure is described in the United States Patent No. 5,221,850 and comprises an Insulated-Gate Bipolar Transistor (IGBT), and a PNP bipolar junction transistor in series with a polysilicon diode connected between the insulated gate and the collector of the IGBT. The PNP bipolar junction transistor has a P+ collector region obtained by diffusion into a lightly doped N-type epitaxial layer ("drift layer") which also constitutes the base region of the IGBT; since the P+ collector region of the bipolar transistor is deeper than the P+ deep body region of the IGBT, the breakdown voltage of the PNP bipolar junction transistor is lower than that of the IGBT.

The abovementioned three examples of power device with overvoltage protection circuit integrated structure share common problems which in many cases vanify the action of the protection circuit: firstly, the clamping voltage value of the protection circuit is affected by a high statistical dispersion, due to the fact that the resistivity and thickness of the lightly doped N-type layers are variable (for a specified value of 350 V, the clamping voltage typically varies in a range of 100 V around the specified value); secondly, the necessity to provide for additional doped layers into the silicon generally requires thermal processes which can alter the doping profiles at the interfaces of the epitaxial layers; thirdly, parasitic components are generally introduced, and precautions must be taken to prevent them from being triggered on.

A possible solution to the first problem provides for exploiting the base and emitter formation steps in power bipolar junction transistors, or the deep body and source formation steps in MOS power devices, to obtain junction diodes with a breakdown voltage of 5-10 V; a plurality of such diodes must be connected in series, in order to achieve an acceptable clamping voltage value; in this way, the clamping voltage does not depend on the resistivity and thickness of the lightly doped N-type layers, but the parasitic component problem is greatly exacerbated.

In view of the state of the art described, the object of the present invention is to provide a power device with overvoltage protection circuit integrated structure which is not affected by the abovementioned problems.

According to the present invention, such object is attained by means of a power device with overvoltage protection circuit integrated structure, comprising at least a first plurality of serially-connected diodes connected between a driving electrode and a first power electrode of the power device, characterized in that said diodes are polysilicon diodes, and each diode comprises a first electrode, constituted by a respective first, heavily doped region of a first conductivity type of a polysilicon layer, and a second electrode, constituted by a respective second, doped region of a second conductivity type of the polysilicon layer, the polysilicon layer being isolated from an underlying silicon layer, wherein the power device is integrated, by an insulating layer.

Thanks to the present invention, it is possible to realize power device with overvoltage protection circuit integrated structures with a clamping voltage not depending on the resistivity and thickness of the silicon layers wherein the power device is integrated; no parasitic components are introduced by the protection circuit, and no thermal steps in addition to those normally required for the fabrication of the power device are necessary.

In a preferred embodiment of the invention, a second plurality of serially-connected polysilicon diodes is provided, the diodes of the second plurality being connected between the driving electrode and a second power electrode of the power device.

A power device with overvoltage protection circuit integrated structure according to the preferred embodiment of the invention is particularly suitable in the case of MOS power devices, such as power MOSFETs and IGBTs, since it provides both output and input protection against overvoltages.

The features of the present invention will be made more evident by the following detailed description of two practical embodiments, illustrated as a non-limiting examples in the annexed drawing, wherein:
Figures 1 to 7 are cross sections of a power device with overvoltage protection circuit integrated structure according to one embodiment of the present invention, taken at intermediate steps of its fabrication process;
Figure 8 is a diagram showing the doping profile of different regions of a polysilicon layer wherein the overvoltage protection circuit is obtained;
Figure 9 is a diagram showing another doping profile of different regions of said polysilicon layer;
Figure 10 is an electric equivalent diagram of the power device with overvoltage protection circuit integrated structure according to this embodiment;
Figure 11 is a current-voltage characteristic of the overvoltage protection circuit according to this embodiment;
Figure 12 is a cross-section of a power device with overvoltage protection circuit integrated structure according to another embodiment of the present invention;
Figure 13 is an electric equivalent diagram of the power device with overvoltage protection circuit integrated structure of Figure 12.

In the following description, it is assumed that the power device is a per-se known conductivity-modulated MOS power device, also called Insulated-Gate Bipolar Transistor (IGBT).

Over a semiconductor substrate 1 with (100) crystallographic orientation and heavily doped with acceptor impurities to achieve a resistivity value of about 10-15 mohm x cm, an N-type layer 2 with donor dopant concentration of about 10¹⁶ atoms/cm³ and thickness of some microns is epitaxially grown.

A lightly doped N- layer 3 with high resistivity value (20-100 ohm x cm) is then epitaxially grown over the N-type layer 2. The N- layer 3 has a thickness ranging from 20 µm to 100 µm.

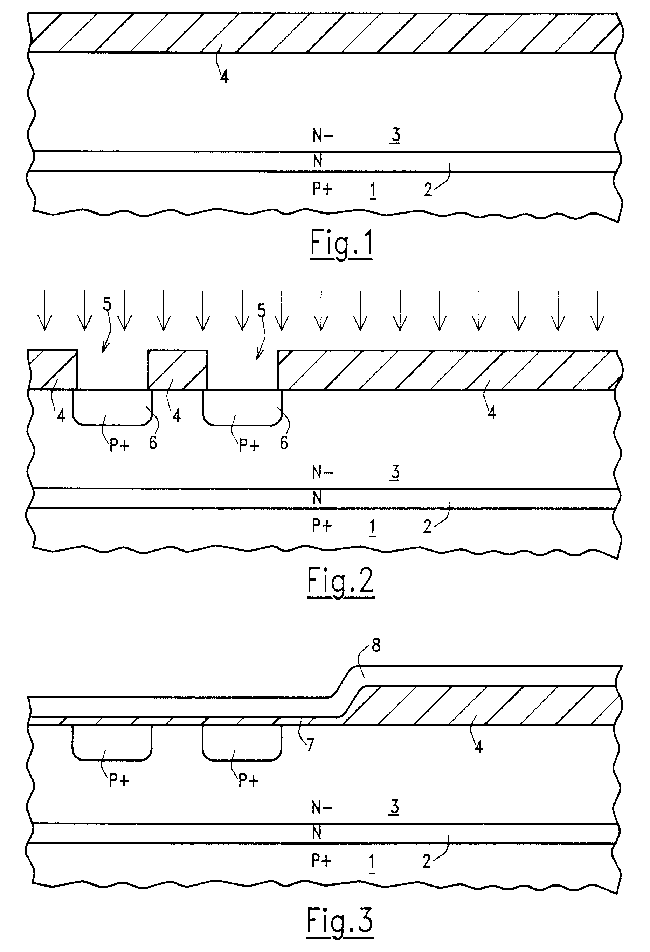

A thick field oxide layer 4, thicker than 1 µm, is then thermally grown over the surface of the N- layer 3 (Fig. 1).

The thick field oxide layer 4 is selectively removed from the surface of the N- layer 3 to open windows 5 through which acceptor impurities (e.g. boron ions) are implanted in high dose (higher than 10¹⁵ atoms/cm2); the implanted acceptor ions are successively made to diffuse into the N- layer 3 to form P+ deep body regions 6 for respective elementary cells of the IGBT (Fig. 2).

The thick field oxide layer 4 is then completely removed from a portion of the N- layer 3 surface under which the elementary cells of the IGBT are to be fabricated (said portion of surface is generally called "active area of the device"); the portion of the N- layer 3 surface whereover the thick field oxide layer 4 is left represents the region wherein an overvoltage protection circuit according to the present invention is to be fabricated.

A thin gate oxide layer 7 is then thermally grown over the surface of the N- layer 3, and a polysilicon layer 8 is deposited over the thin gate oxide layer 7 and over the thick field oxide layer 4 (Fig. 3).

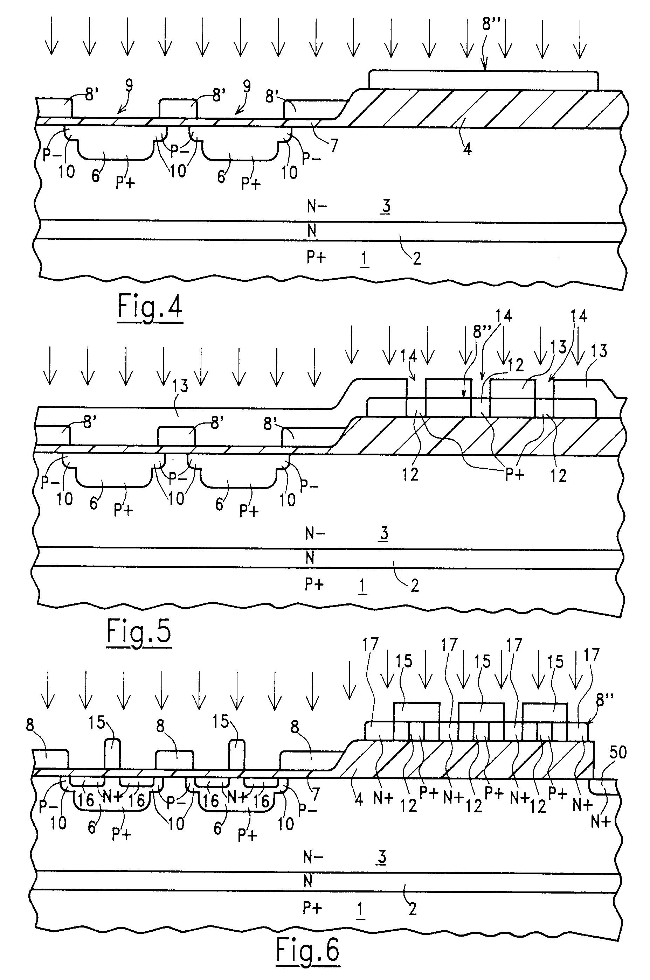

The polysilicon layer 8 is then selectively removed to open windows 9 through which acceptor impurities (e.g. boron ions) are implanted into the N- layer 3 in a dose of about 10¹³ atoms/cm²; the implanted acceptor ions are then made to diffuse to form P- body regions 10 of the IGBT elementary cells; the P- body regions 10 will constitute channell regions of the IGBT elementary cells, and the doping level of the P-body regions 10 determines therefore the threshold voltage of the IGBT. The remaining polysilicon layer strips 8' over the thin gate oxide layer 7 form a mesh which will constitute a gate electrode of the IGBT. An isle 8'' of polysilicon layer 8, detached from the mesh of polysilicon layer strips 8', is left over the thick field oxide layer 4. During the implantation step for the formation of the P- body regions 10, acceptor ions are also introduced into the polysilicon isle 8'' and into the polysilicon strips 8', which therefore achieve a light P-type doping (Fig. 4).

A photoresist layer 13 is then deposited over the whole surface, and is selectively removed to open windows 14 over the polysilicon isle 8''. The photoresist layer 13 acts as a mask for a subsequent implantation of a high dose of acceptor ions (e.g. boron); after the implantation, P+ polysilicon strips 12 are obtained in the polysilicon isle 8'' (Fig. 5); the number of P+ polysilicon strips 12 in the polysilicon isle 8'' depends on the number of polysilicon diodes which will constitute the overvoltage protection circuit.

The photoresist layer 13 is then completely removed.

Another photoresist layer 15 is deposited over the whole surface, and is selectively removed over the active area of the device to form a mask for the formation of source regions 16 of the IGBT elementary cells. The photoresist layer 15 is also selectively removed over the polysilicon isle 8''.

Donor impurities (e.g. arsenic ions) are then implanted in a high dose (10¹⁵ atoms/cm²) to obtain the N+ source regions 16 of the IGBT elementary cells and an N+ contact region 50 to the N- layer 3, and into the uncovered regions of the polysilicon isle 8'' to form N+ polysilicon strips 17 (Fig. 6). The N+ polysilicon strips 17 are separated from the previously obtained P+ polysilicon strips 12 by P- polysilicon strips 18, representing regions of the polysilicon isle 8'' which have been lightly doped during the formation of the P- body regions 10 of the IGBT elementary cells, and which have not been subsequently exposed to the implantation of dopant impurities.

The photoresist layer 15 is then completely removed.

A dielectric layer 19 (generally a chemical-vapour deposited oxide doped with phosphor, known as PVapox) is deposited over the whole surface; contact windows are opened in the dielectric layer 19 both in the active area region of the device and over the polysilicon isle 8''.

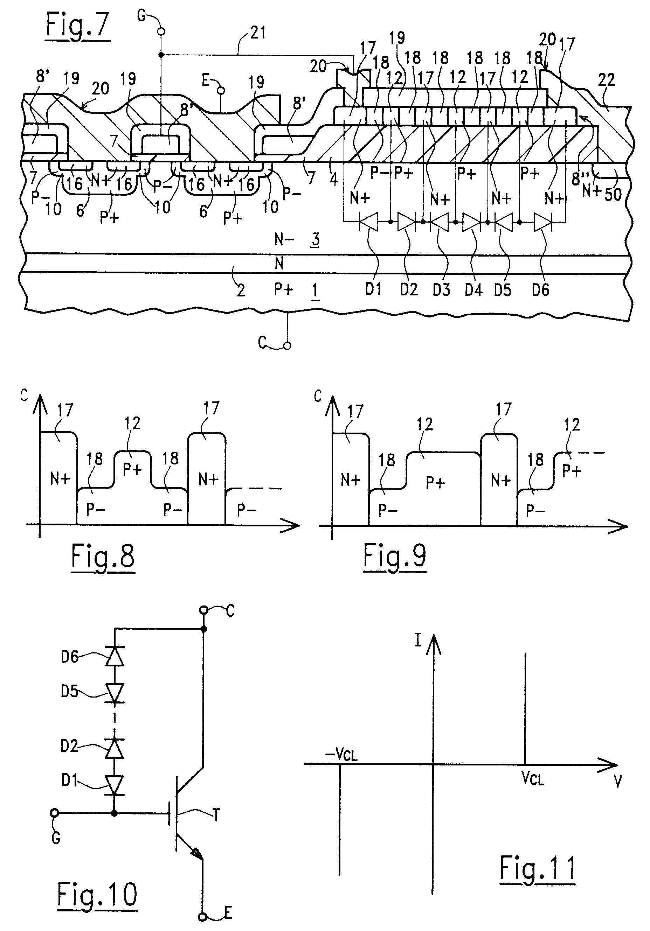

A metal conductive layer 20 (e.g. an aluminum layer) is deposited over the dielectric layer 19. The metal conductive layer 20 contacts the P+ deep body regions 6 and the source regions 16 of all the IGBT elementary cells. The metal conductive layer 20 also contacts two N+ polysilicon strips 17 located at opposite sides of the polysilicon isle 8'', and the N+ contact region 50. The metal conductive layer 20 is selectively removed to obtain the desired pattern of interconnection lines (Fig. 7).

The alternated N+, P- and P+ polysilicon strips 17, 18 and 12 obtained in the polysilicon isle 8'' form a chain of pairs of "back-to-back" connected polysilicon diodes D1-D6 (Fig. 7): each of said diodes has a cathode region constituted by an N+ polysilicon strip 17, and an anode region constituted by a P-polysilicon strip 18; the P+ polysilicon strips 12 between each pair of P- polysilicon strips 18, acting as field stoppers, allow to obtain polysilicon diodes with a precise breakdown voltage of about 10 V. Thanks to the symmetry of the doping profiles shown in Figure 8, each pair of back-to-back connected polysilicon diodes D1,D2-D5,D6 shows a current-voltage characteristic which is simmetrical with respect to the current I axis. The chain of pairs of back-to-back connected diodes D1,D2-D5,D6 shows therefore the overall current-voltage characteristic sketched in Figure 11, wherein the V axis represents the values of the voltage between the cathode region of the diode D6 and the cathode region of the diode D1, and V_{CL} is the clamping voltage of the overvoltage protection circuit, sum of the breakdown voltages of the diodes D2, D4 and D6 (V_{CL} = 30 V in the example).

In the embodiment of Figure 7, the anode of a first diode D1 of the chain D1-D6 is connected, via a metal strip 21, to a gate electrode G of the IGBT which is also connected to the mesh of polysilicon strips 8'; the anode of a last diode D6 of the chain D1-D6 is instead connected, via a metal strip 22, to the N+ contact region 50 to the N- layer 3; a collector electrode C of the IGBT is also connected to the P+ substrate 1: the circuit of Figure 10 is thus obtained, which is suitable to protect the IGBT T against overvoltages occurring at its collector terminal (i.e. at its output).

The number of pairs of back-to-back connected diodes D1,D2-D5,D6 is determined on the basis of the desired clamping voltage value V_{CL}, each pair of polysilicon diodes contributing for 10 V to the overall clamping voltage value V_{CL}. If a finer tuning of the clamping voltage V_{CL} is desired, it is possible to change the geometry and pattern of windows 14 opened in the photoresist layer 13 in Figure 5 to obtain the doping profile shown in Figure 9: N+/P- polysilicon diodes, with a breakdown voltage of about 10 V, can thus be intercalated to N+/P+ polysilicon diodes with a breakdown voltage of about 5 V.

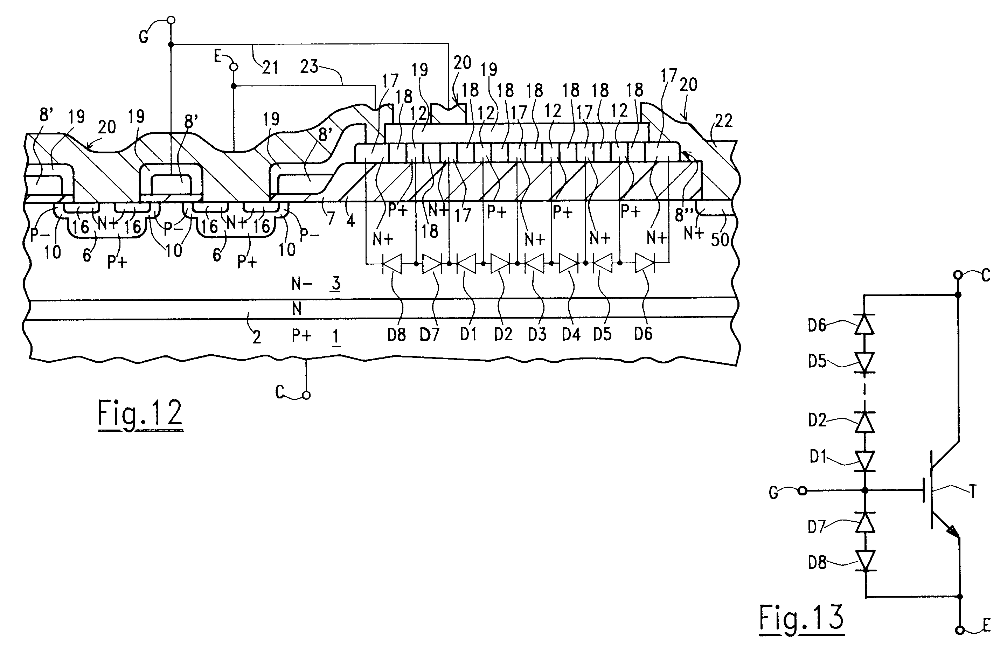

The overvoltage protection circuit shown in Figure 7 is actually more suitable to protect bipolar power devices than MOS power devices, since it does not protect the power device against overvoltages occurring at the control electrode G; in Figure 12 an embodiment is shown which is instead more suitable to MOS power devices, such as the IGBT: an N+ polysilicon strip 17 at the edge of the polysilicon isle 8'' is now connected by a metal interconnection line 23 to an emitter electrode E of the IGBT (for example by extending the same portion of metal conductive layer 20 which also contacts the N+ source regions 16 of the IGBT elementary cells over the polysilicon isle 8''); an intermediate N+ polysilicon strip 17 in the polysilicon isle 8'' is connected by the metal strip 21 to the gate electrode G of IGBT, as in the embodiment of Figure 7; the N+ polysilicon strip 17 at the opposite edge of the polysilicon isle 8'' is connected, via the metal strip 22, to the N+ contact region 50 to the N- layer 3, as in the embodiment of Figure 7. The overvoltage protection circuit thus obtained comprises a first chain of pairs of back-to-back connected polysilicon diodes D1,D2-D5,D6 connected, as in the previous embodiment, between the gate electrode G and the collector electrode C of the IGBT T, and a second chain of pairs of back-to-back connected diodes D7,D8 (actually only one pair in the example) connected between the gate electrode G and the emitter electrode E of the IGBT T (Fig. 13). The diodes D1-D6 protect the IGBT T against overvoltages taking place at its collector terminal (i.e. at the output of the IGBT), as in the previous embodiment, while the diodes D7 and D8 protect the IGBT against overvoltages on the gate electrode G (i.e. at the driving input of the IGBT). The number of diodes between the electrodes G and C, as well as between the electrodes G and E, can be varied, depending on the desired clamping voltage: this just requires a change in the mask defining the contact openings in the dielectric layer 19, and in the mask defining the pattern of metal interconnection lines; a lower number of diodes is generally required between G and E, since the maximum voltage sustainable by the thin gate oxide 7 is no higher than few tens of volts.

If the power device is a power MOSFET instead of an IGBT, it is only necessary to start from a heavily doped N-type substrate 1; further, the N-type layer 2 is no more necessary.

If the power device is a power bipolar device, the starting substrate 1 is of the same conductivity type as the lightly doped epitaxial layer 3, i.e. N-type; after the growth of the thick field oxide layer 4, and its selective removal from an active area portion of the N- layer 3 wherein the power bipolar device will be fabricated, the polysilicon layer 8 is formed only over the field oxide layer 4 (differently from MOS power devices,this step is normally not provided for in the manufacturing processes of power bipolar devices ), to obtain the polysilicon isle 8''. A medium to low dose of acceptor impurities (e.g. boron ions) is implanted into the N- layer 3 to form at least one P-type base region of the power bipolar device, and simultaneously to lightly dope the polysilicon isle 8''. P+ polysilicon strips 12 are again formed in the polysilicon isle 8'' by selectively introducing a high dose of acceptor impurities (exactly as in the case of the IGBT); the N+ polysilicon strips 17 are instead formed during the implantation step of a high dose of donor impurities to form at least one N+ emitter region of the power bipolar device inside the P-type base region.

## Claims

1. Power device with overvoltage protection circuit integrated structure, comprising at least a first plurality of serially-connected diodes (D1-D6) connected between a driving electrode (G) and a first power electrode (C) of the power device (T), characterized in that said diodes (D1-D6) are polysilicon diodes, and each diode (D1-D6) comprises a first electrode, constituted by a respective first, heavily doped region (17) of a first conductivity type of a polysilicon layer (8''), and a second electrode, constituted by a respective second, doped region (18,12) of a second conductivity type of the polysilicon layer (8''), the polysilicon layer (8'') being isolated from an underlying silicon layer (3), wherein the power device (T) is integrated, by an insulating layer (4).

2. Power device with overvoltage protection circuit integrated structure according to claim 1, characterized in that said first regions (17) of the polysilicon layer (8'') are alternated with said second regions (18,12) of the polysilicon layer (8''), each second region (18,12) of the polysilicon layer (8'') forming a common second electrode for a respective pair of back-connected diodes (D1,D2-D5,D6) of said first plurality of polysilicon diodes (D1-D6), and each first region (17) of the polysilicon layer (8'') between two second regions (18,12) of the polysilicon layer (8'') forming a common first electrode for two respective diodes of two adjacent pairs of back-connected diodes (D1,D2-D5,D6).

3. Power device with overvoltage protection circuit integrated structure according to claim 2, characterized in that each second region (18,12) of the polysilicon layer (8'') comprises a heavily doped region (12) of a second conductivity type and at least one lightly doped region (18) of the second conductivity type.

4. Power device with overvoltage protection circuit integrated structure according to claim 3, characterized in that each second region (18,12) of the polysilicon layer (8'') comprises said heavily doped region (12) of the second conductivity type, interposed between two of said lightly doped regions (18) of the second conductivity type.

5. Power device with overvoltage protection circuit integrated structure according to claim 1, characterized in that it comprises a second plurality of serially-connected polysilicon diodes (D7,D8) connected between said driving electrode (G) and a second power electrode (E) of the power device (T).

6. Power device with overvoltage protection circuit integrated structure according to claim 5, characterized in that each polysilicon diode (D7,D8) of said second plurality comprises a first electrode constituted by one respective first region (17) of the polysilicon layer (8''), and a second electrode constituted by one respective second region (18,12) of the polysilicon layer (8'').

7. Power device with overvoltage protection circuit integrated structure according to claim 6, characterized in that said first regions (17) and said second regions (18,12) of the polysilicon layer (8'') are alternated one to another, each second region (18,12) of the polysilicon layer (8'') forming a common second electrode for a respective pair of back-connected diodes (D1,D2-D7,D8) of said first and second pluralities of polysilicon diodes (D1-D6;D7-D8), and each first region (17) of the polysilicon layer (8'') between two second regions (18,12) of the polysilicon layer (8'') forming a common first electrode for two respective diodes of two adjacent pairs of back-connected diodes (D1,D2-D7,D8).

8. Power device with overvoltage protection circuit integrated structure according to anyone of the preceding claims, characterized in that said first regions (17) of the polysilicon layer (8'') are N-type polysilicon regions, and said second regions (18,12) of the polysilicon layer (8'') are P-type polysilicon regions.

9. Power device with overvoltage protection circuit integrated structure according to anyone of the preceding claims, characterized in that the power device is a power bipolar junction transistor.

10. Power device with overvoltage protection circuit integrated structure according to anyone of claims 1 to 8, characterized in that the power device is a power MOSFET.

11. Power device with overvoltage protection circuit integrated structure according to anyone of claims 1 to 8, characterized in that the power device is an insulated gate bipolar transistor.

12. A process for the manufacturing of a power device with overvoltage protection circuit integrated structure, comprising the steps of:
a) over a heavily doped silicon substrate (1), forming a lightly doped silicon layer (3) of a first conductivity type;
b) forming a thick oxide layer (4) over the lightly doped silicon layer (3);
c) removing the thick oxide layer (4) from an active area portion of the lightly doped silicon layer (3) wherein the power device is to be fabricated;
d) forming a polysilicon layer (8) at least over the thick oxide layer (4);
e) introducing into the polysilicon layer (8) and into selected regions of the active area portion of the lightly doped silicon layer (3) a low dose of dopant impurities of a second conductivity type, to obtain a lightly doped polysilicon isle (8'') of the second conductivity type over the thick oxide layer, and to form at least one first doped region (10) of the power device inside the lightly doped silicon layer (3);
f) selectively introducing into the polysilicon isle (8'') a high dose of dopant impurities of the second conductivity type to form heavily doped polysilicon regions (12) of the second conductivity type;
g) selectively introducing into the polysilicon isle (8''), and into selected regions of the active area portion of the lightly doped silicon layer (3) a high dose of dopant impurities of the first conductivity type to form heavily doped polysilicon regions (17) of the first conductivity type separated by one heavily doped polysilicon region (12) of the second conductivity type and by at least one lightly doped polysilicon region (18) of the second conductivity type, and to form at least one second doped region (16) of the power device inside said at least one first doped region (10);
h) forming an insulating layer (19) over said active area portion of the lightly doped silicon layer (3) and over the polysilicon layer (8);
i) selectively removing the insulating layer (19) to open contact windows to selected regions of said active area of the device and to a first one of said heavily doped polysilicon regions (17) of the first conductivity type and to at least one second one of said heavily doped polysilicon regions (17) of the first conductivity type;
l) forming a metal conductive layer (20) over said insulating layer (19);
m) selectively removing the metal conductive layer (20) to form a pattern of metal interconnection lines, one metal interconnection line (21) connecting said first one heavily doped polysilicon region (17) of the first conductivity type to a driving electrode (G) of the power device, and another metal interconnection line (22,23) connecting said at least one second heavily doped polysilicon region (17) of the first conductivity type to a respective power electrode (C,E) of the power device.
